# EUROPEAN PATENT APPLICATION

(11) **EP 4 373 223 A1**
(43) Date of publication of application: **22.05.2024**
(21) Application number: 23209430.0
(22) Date of filing: 13.11.2023
(51) Int. Cl.: H05K 1/03, H05K 3/46, H01L 23/15, H01L 21/56, H01L 23/498, H01L 23/00

(54) **SUBSTRATE AND SEMICONDUCTOR MODULE**

(30) Priority: 15.11.2022 US 202263425670 P
(71) Applicant: Absolics Inc., Covington, GA 30014 (US)
(72) Inventor: KIM, Tae Kyoung, Covington, 30014 (US); WOO, Yong Ha, 18469 Hwaseong-si, Gyeonggi-do (KR); KIM, Sungjin, Covington, 30014 (US); OH, Jun Rok, 18469 Hwaseong-si, Gyeonggi-do (KR)
(74) Representative: BCKIP Part mbB

(57) **Abstract**

An embodiment relates to a substrate and a semiconductor module. A substrate capable of manufacturing a substrate for packaging, which is an individual product, with excellent yield despite cracks that may occur at edges or side surfaces of a core is provided.

The substrate comprises a core as a glass or ceramic support, wherein the substrate is divided into a product region and a dummy region, the product region is a region where one or more individual products are disposed, the dummy region is a region of the substrate other than the product region, a breakage prevention portion is disposed in the product region or the dummy region, wherein the breakage prevention portion is a region in which one or more crack stopping structures are disposed, and the crack stopping structure is grooves or vias who stops cracks generated from the side of the core from growing toward the center of the individual product, and wherein the groove is a depression in a surface of the core, and the via is a through hole that has been removed so that a portion of the core being penetrate in a thickness direction.

## Description

### BACKGROUND

### 1. Field of the Invention

Embodiments relate to a substrate including a core that is a support substrate of a packaging substrate or a packaging substrate including the core.

Embodiments relate to a semiconductor module including the substrate.

### 2. Discussion of Related Art

In manufacturing electronic components, implementing a circuit on a semiconductor wafer is called a front-end (FE) process, assembling the wafer in a state of being usable in an actual product is called a back-end (BE) process, and a packaging process is included in subsequent processes.

The four core technologies of the semiconductor industry which recently enabled rapid development of electronic products include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like but a relatively perfect packaging technology is not supported. Accordingly, the electrical performance of a semiconductor can sometimes be determined by the packaging technology and an electrical connection according to the packaging technology rather than the performance of the semiconductor technology itself.

A ceramic or resin has been applied as a material of a substrate for packaging. In the case of ceramic substrates, it is difficult to mount a high-performance and high-frequency semiconductor element due to their high resistance or high dielectric permittivity. In the case of resin substrates, a relatively high-performance and high-frequency semiconductor element can be mounted, but there is a limit to reducing the pitch of lines.

### SUMMARY OF THE INVENTION

An embodiment is directed to providing a substrate whose manufacturing yield is excellent. An embodiment is directed to providing a substrate capable of manufacturing a packaging substrate as an individual product with excellent yield despite cracks that may occur at edges or side surfaces of a core.

Further, an embodiment is directed to providing a semiconductor module to which the packaging substrate is applied.

In order to achieve the above objects, a substrate according to one or more embodiment is a substrate including a core as a glass or ceramic support, wherein the substrate is divided into a product region and a dummy region, the product region is a region where one or more individual products are disposed, the dummy region is a region of the substrate other than the product region, a breakage prevention portion is disposed in the product region or the dummy region, the breakage prevention portion is a region in which one or more crack stopping structures are disposed, the crack stopping structure is grooves (concave) or vias who stops cracks generated from the side of the core from growing toward the center of the individual product, the groove is a depression in a surface of the core, and the via is a through hole that has been removed so that a portion of the core being penetrate in a thickness direction.

The individual product has a cutting line, a center point, and an inner border when viewed from above. The cutting line is a line forming an outline of the individual product when the individual product is separated (singulation), the center point is an imaginary point corresponding to a geometric center of the individual product, and the inner border line is an imaginary line that approaches the center point as much as 20% of a length from the cutting line.

The breakage prevention portion may include a plurality of grooves or vias disposed adjacent to a boundary line between the product area and the dummy area.

In one or more embodiment, the groove or via may have an opening having a diameter A, and a pitch of the grooves or vias adjacent to each other may be 1.3 to 20 times A.

In one or more embodiment, the crack stopping structure may include a curved structure in which the grooves or vias are disposed along a shape of an edge of the individual product.

In one or more embodiment, the groove may be a filled groove, the via may be a filled via, and an opening of the groove or via may come into contact with a via pad.

In one or more embodiment, the crack stopping structure may further include a side surface protection layer. The side surface protection layer may be a structure covering a part or all of side surfaces of the core.

In one or more embodiment, the substrate may further include a stabilization layer configured to cover the core. The stabilization layer may cover surfaces including an upper surface and a lower surface of the core.

In one or more embodiment, a surface including the side surface of the core, a portion of the upper surface connected to the side surface, and a portion of the lower surface connected to the side surface may be a side surface to be protected, and the side surface protection layer may be disposed on part or all of the side surface to be protected.

The stabilization layer may include any one selected from the group consisting of a metal, a polymer, a glass fiber, and a combination thereof.

The side surface protection layer may include an insulating layer.

The insulating layer may include inorganic particles dispersed in a polymer resin.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawings, in which:
FIGS. 1, 2, 3, 4, and 5 are conceptual diagrams of substrates of various embodiments viewed from above.
FIGS. 6, 7, 8, 9, 10, and 11 are conceptual diagrams for describing the substrates of various embodiments through a portion indicated by A in FIG. 5.
FIGS. 12, and 13 are a conceptual diagram for describing a substrate of various embodiments with a cross-section taken along b-b' in FIG. 3.
FIG. 14 is a conceptual diagram for describing a cross-section of a packaging substrate of various embodiments.
FIG. 15 is a conceptual diagram for describing a semiconductor module according to one or more embodiments from a top view.
FIG. 16 is a conceptual diagram for describing a semiconductor module of various embodiments with a cross-section.
FIG. 17 is a conceptual diagram for describing a cross sectional view of FIG. 15's X-X'.
FIGS. 18, 19, and 20 are conceptual diagrams for describing the semiconductor module of various embodiments with a cross-section.
FIGS. 21, 22, 23, 24, 25, 26, 27, 28, 29, 30, and 31 are conceptual diagrams for describing a crack stopping structure applicable to various embodiments.

### DETAILED DESCRIPTION OF EXEMPLARY EMBODIMENTS

Hereinafter, embodiments will be described in detail with reference to the accompanying drawings which may allow those skilled in the art to easily practice the present disclosure. However, the embodiment may be implemented in various forms and is not limited to the embodiments described herein. The same reference numerals are used for similar components throughout the specification.

Throughout the present specification, the term "combination thereof" included in expression of the Markush form refers to a mixture or combination of one or more selected from the group consisting of components disclosed in the expression of the Markush form, and refers to including one or more selected from the group consisting of the components.

Throughout the present specification, terms such as "first," "second," "A" or "B" are used to distinguish the same terms. Further, a singular form includes a plural form unless otherwise defined in the context.

In the present specification, "-based" may refer to including a compound corresponding to "-" or a derivative of the "~" in the compound.

In the present specification, "B is located on A" means that B is located directly on A or B is located on A while another layer is located therebetween, and is not understood as being limited to a case in which B is located on the surface of A.

In the present specification, "B is connected on A" means that B is directly connected to A or B is connected to A through another component therebetween, and is not understood as being limited to a case in which B is directly connected to A unless otherwise specifically mentioned.

In the present specification, a singular form is interpreted as including a singular form or plural form unless otherwise specifically described.

In the present specification, high frequency refers to a frequency of approximately 1 GHz to approximately 300 GHz. Specifically, high frequency may refer to a frequency of approximately 1 GHz to approximately 30 GHz, and may refer to a frequency of approximately 1 GHz to approximately 15 GHz.

In the present specification, unless otherwise described, a fine line refers to a line having a width of 5 µm or less, for example, refers to a line having a width of 1 to 4 µm or less.

In the present specification, shapes, relative sizes, angles, and the like of components in the drawings are illustrative and may be exaggerated for the purpose of description, and the scope is not understood as being limited to the drawings.

In the present specification, a core refers to a board type support member disposed in a substrate.

In the present specification, a packaging substrate is a product manufactured by cutting a substrate, and refers to a board type member on which a redistribution layer, a solder resist layer, and the like are disposed to mount an element.

In the present specification, the substrate is a substrate before being cut into the packaging substrate and includes a core as a support. The substrate may be a strip substrate in which a plurality of individual products is arranged with a dummy area in between; a quart substrate with a dummy area disposed between the plurality of strips; Alternatively, it may be a panel substrate in which a dummy area is disposed between a plurality of the quarts. For convenience of description, these are all referred to as substrates.

Depending on the context, the substrate may be interpreted as having an electrically conductive layer and/or an insulating layer disposed on the core, may be interpreted as having an electrically conductive layer, an insulating layer, and a solder resist layer disposed on the core, and may be interpreted as further including a bump. Further, the substrate may mean that a plurality of packaging substrates that are not cut and are connected to each other are disposed in parallel or with a dummy region therebetween.

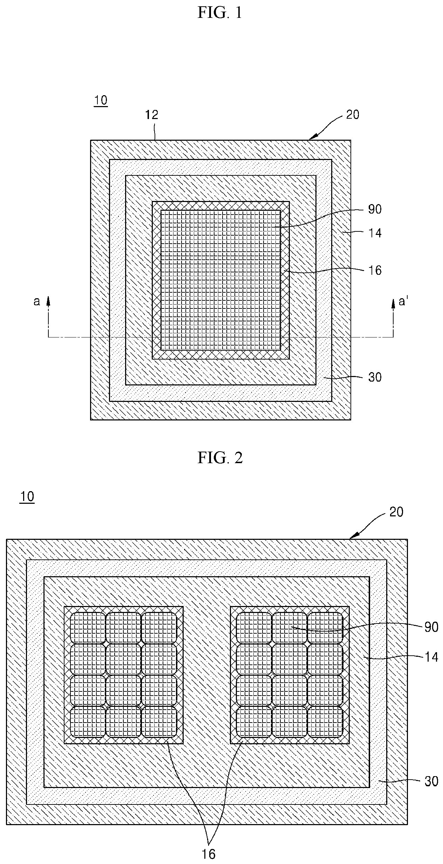

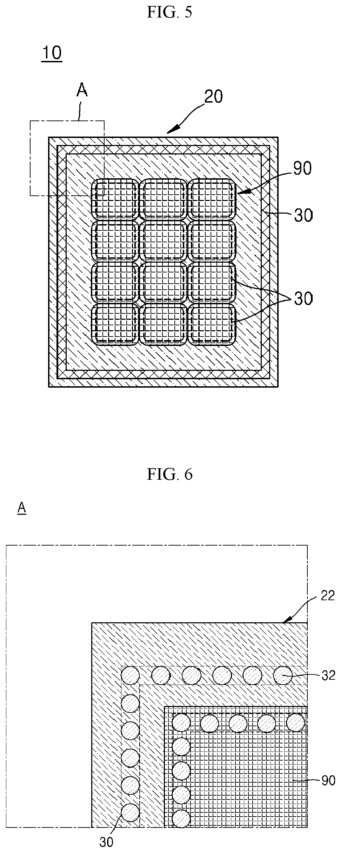

FIGS. 1, 2, 3, 4, and 5 are conceptual diagrams of substrates of various embodiments viewed from above. FIGS. 6, 7, 8, 9, 10, and 11 are conceptual diagrams for describing the substrates of various embodiments through a portion indicated by A in FIG. 5.

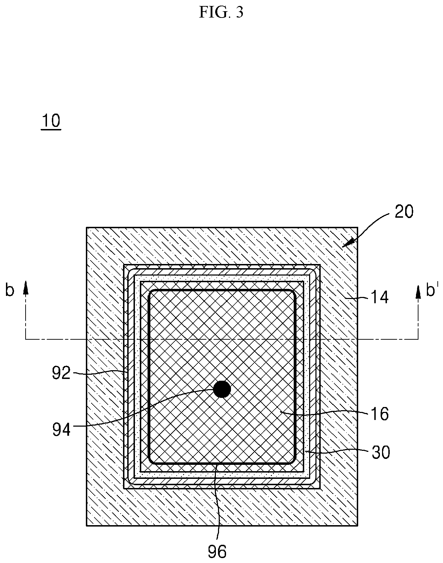

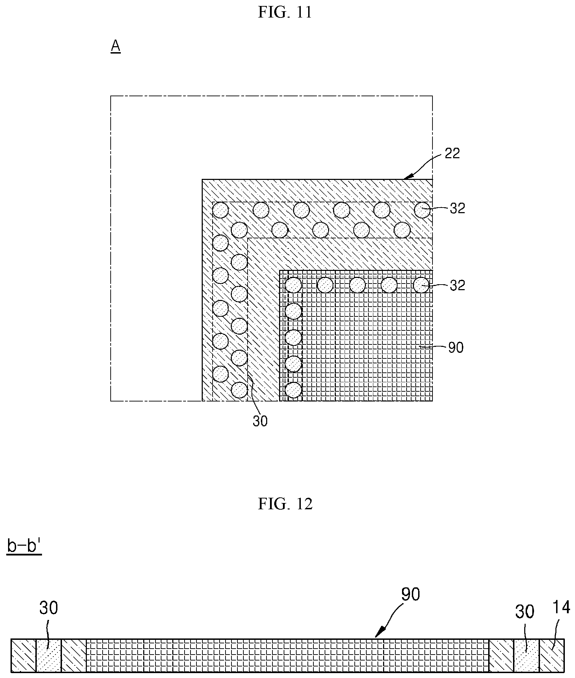

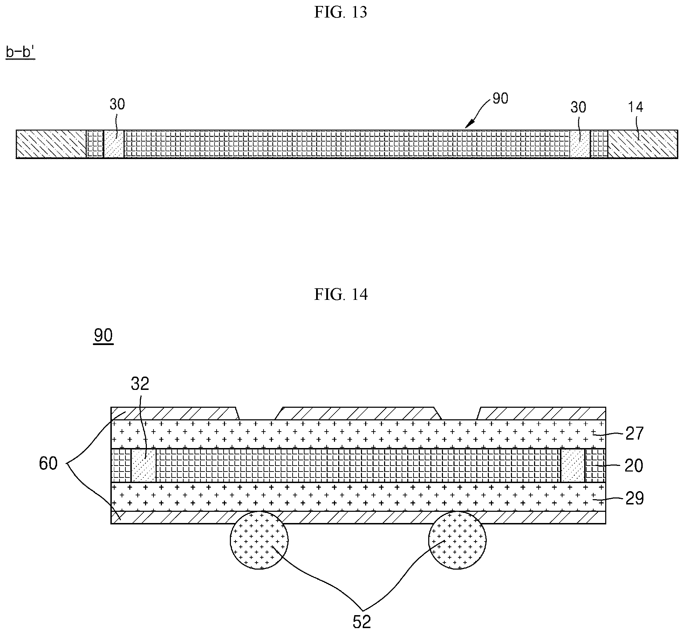

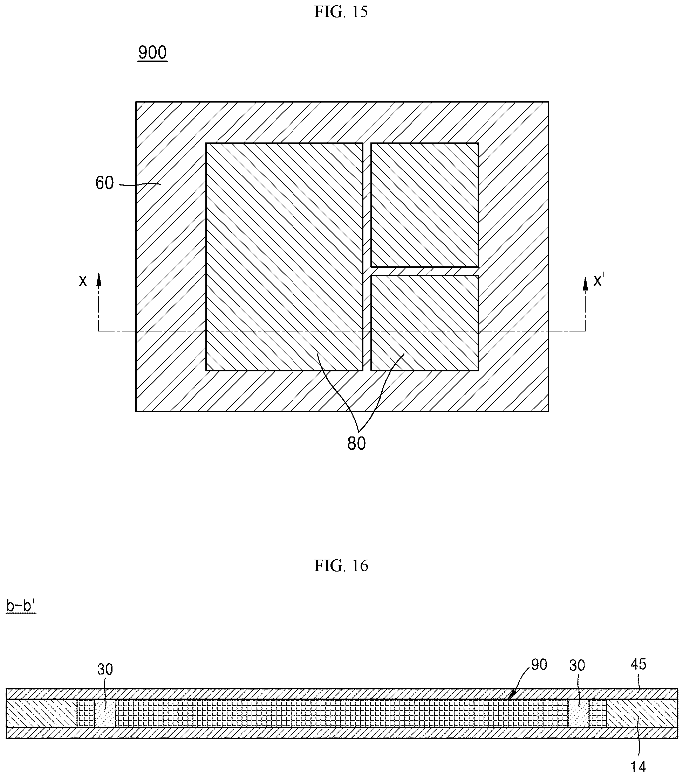

FIGS. 12 and 13 are a conceptual diagram for describing a substrate of various embodiments with a cross-section taken along b-b' in FIG. 3. FIG. 14 is a conceptual diagram for describing a cross-section of a packaging substrate of various embodiments. FIG. 15 is a conceptual diagram for describing a semiconductor module from a top view.

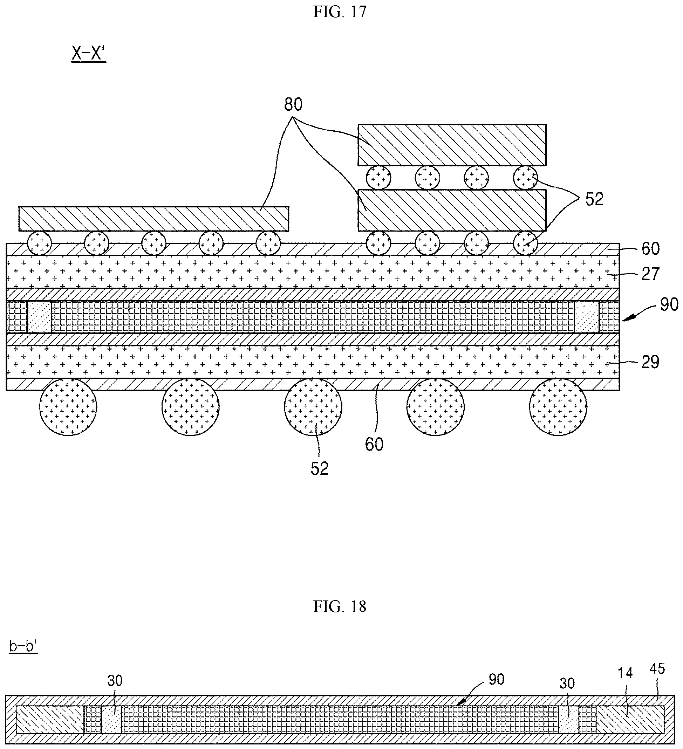

FIG. 16 is a conceptual diagram for describing a semiconductor module of various embodiments with a cross-section. FIG. 17 is a conceptual diagram for describing a cross sectional view of FIG. 15's X-X'. FIGS. 18, 19, and 20 are conceptual diagrams for describing the substrates of various embodiments with a cross-section.

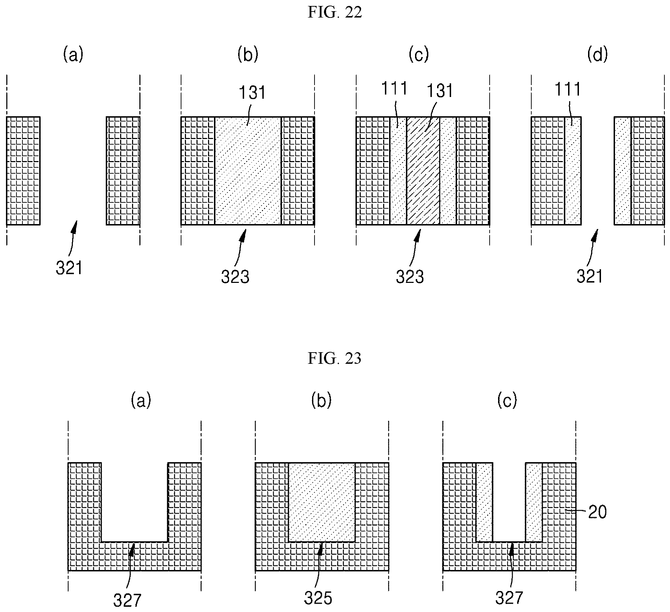

FIGS. 23, 24, 25, 26, 27, 28, 29, 30, and 31 are conceptual diagrams for describing a crack stopping structure applicable to various embodiments.

Hereinafter, the embodiments will be described in detail with reference to the drawings.

In order to achieve the above objects, the substrate 10 of the embodiment may be used as a core 20 as a support of a semiconductor packaging substrate, and includes a breakage prevention portion 30 disposed in the core 20.

The substrate 10 may be distinguished into a product region 16 and a dummy region 14.

The product region 16 is a region where one or more components that are cut into individual products and constitute the packaging substrate (referred to as individual products for convenience) are disposed.

The dummy region 14 is a region in the core 20 other than the product region 16.

The substrate 10 of the embodiment includes a breakage prevention portion 30 disposed in the dummy region 14 (see FIGS. 1 and 2).

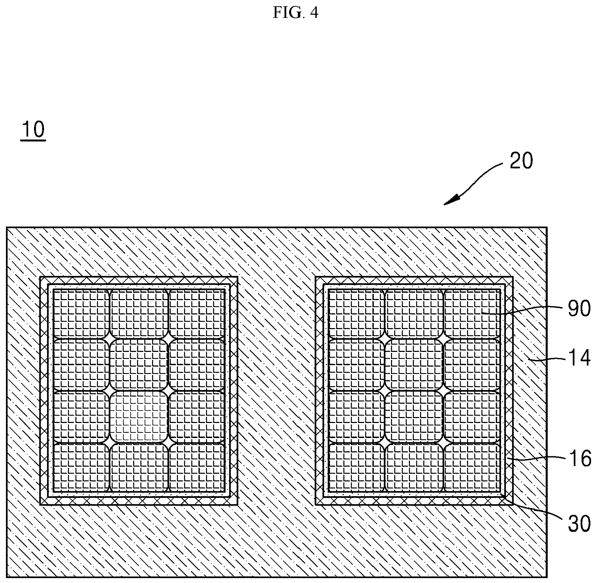

The substrate 10 of the embodiment includes a breakage prevention portion 30 disposed in the product region 16 (see FIGS. 3 and 4).

The substrate 10 of the embodiment includes a breakage prevention portion 30 disposed in the product region 16 and the dummy region 14 (see FIG. 5).

The substrate 10 of the embodiment includes a breakage prevention portion 30 disposed in the dummy region 14, the product region 16 and an individual product 90 (not shown).

The breakage prevention portion can suppress the progress of cracks generated at the edge or edge of the core by arranging a crack stop structure, thereby suppressing the increase in damage to the core.

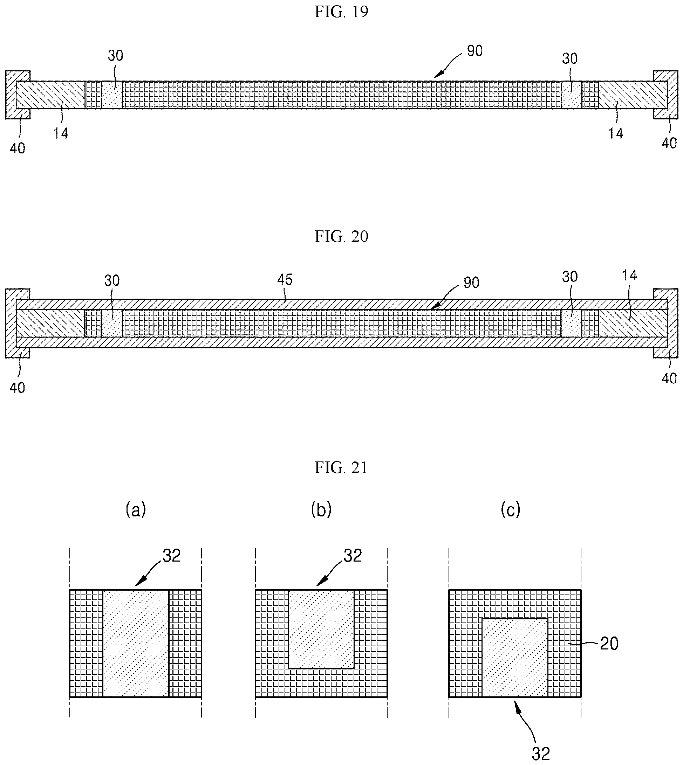

Crack stop structures 32 are disposed in the breakage prevention portion 30. The crack stop structures 32 is a concave or via formed in the core (see FIG. 21) and suppresses the progression of the crack.

The groove is a depression in a surface of the core.

The via is a through hole that has been removed so that a portion of the core being penetrate in a thickness direction.

In the crack stopping structure 30, a groove, a via, or a mixture thereof may be disposed, and may be disposed in large numbers in the form of regular rows or irregular rows.

A board type member may be applied as the core 20. The core 20 may be selected from a silicon-based ceramic substrate, a glass-based ceramic substrate, a glass substrate, and a combination thereof.

An inorganic material-based board type member may be applied as the core 20 to overcome the implementation limitations of line-space and integrate semiconductor modules.

For example, a silicon-based ceramic substrate, a glass-based ceramic substrate, or the like may be applied as the core 20. The silicon-based ceramic substrate may be a substrate including part or all of a silicon substrate, a silicon carbide substrate, or the like. The glass-based ceramic substrate may be a substrate including part or all of a quartz substrate, a sapphire substrate, or the like.

When a glass-based ceramic substrate or plate glass is applied as the core 20, the generation of parasitic elements may be suppressed due to its insulating properties, and power efficiency can be improved when it is applied to a high-frequency semiconductor packaging substrate.

For example, alkaline borosilicate plate glass, alkali-free borosilicate plate glass, alkali-free alkaline earth borosilicate plate glass, or the like may be applied as the glass substrate (plate glass), and any type of plate glass applied to an electronic component may be applied as the glass substrate (plate glass).

A thickness of the core 20 may be 50 µm or more, 100 µm or more, 250 µm or more, 400 µm or more, and 500 µm or more. The thickness of the core may be 3000 µm or less, 1000 µm or less, and 800 µm or less. When a core with this thickness range is applied, the core may have excellent usability as a substrate for semiconductor packaging.

Although not indicated in the drawings, the core 20 may have conductive through vias formed therein to be appropriately applied to a support layer of a semiconductor or a substrate for semiconductor packaging, and may have a cavity as necessary.

One or more breakage prevention portions 30 may be disposed independently of each other.

The breakage prevention portions 30 may be disposed along edges of the core 20.

The breakage prevention portions 30 may be disposed along edges of the product region 16.

The breakage prevention portions 30 may be disposed along edges of the individual product 90.

Arranged along the edge means that the breakage prevention portion is arranged in the form of a dotted line, etc., generally following the shape of the edge, either inside or outside the edge (limited to cases where placement is possible).

At least a portion of the breakage prevention portion 30 may be disposed at a boundary or in the product region 16.

When disposed in the dummy region 14, the breakage prevention portion may be removed during a cutting (singulation) process in a substrate manufacturing process and may not remain in an individual product 90. However, when part of the breakage prevention portion 30 is disposed in the product region 16, especially in the individual product 90 (the packaging substrate), the breakage prevention portion 30 may be identified in a cross-section or the like of the individual product 90.

Illustratively, the individual product 90 has a cutting line 92, a center point 94, and an inner border 96 when viewed from above (see FIG. 3, etc.)

The cutting line 92 is a line forming an outline of the individual product when the individual product is separated (singulation). The center point 94 is an imaginary point corresponding to a geometric center of the individual product. The inner border line 96 is an imaginary line that approaches the center point as much as approximately 20% of a length from the cutting line, and may be an imaginary line that approaches the center point as much as approximately 15% of the length or approximately 10% of the length.

The breakage prevention portion 30 may be disposed between the cutting line and the inner border. At least a portion of the breakage prevention portion may be located between the cutting line and the inner border.

The crack stopping structure 32 may be configured in various forms by arranging grooves and/or vias.

As an example, the crack stopping structure 32 may have a plurality of grooves or vias arranged in a row adjacent to the boundary line between the product region 16 and the dummy region 14.

As an example, the crack stopping structure 32 may include adjacent grooves (or vias) having a pitch of 1 or more. The pitch may be 1.2 or more, 1.3 or more, 1.4 or more, or 1.5 or more. The pitch may be 20 or less, 16 or less, 10 or less, 8 or less, 4 or less, or 2 or less. When a diameter of an opening of the groove (or via) is A, the pitch refers to how many times A is a distance between adjacent grooves (or vias) and a center.

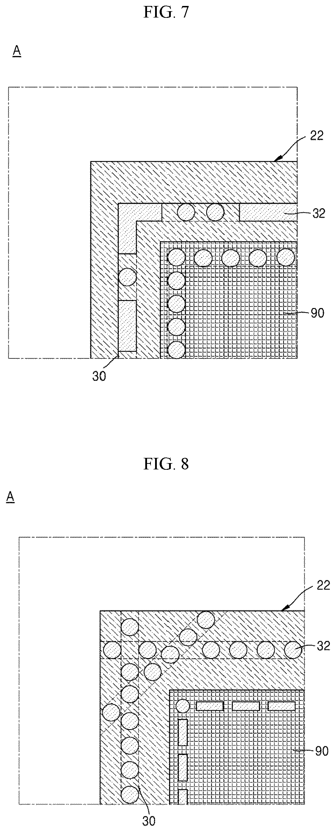

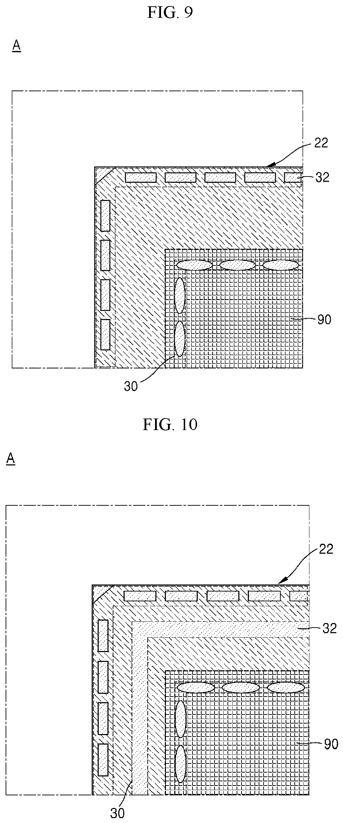

The crack stopping structure 32 may be disposed in a predetermined arrangement. For example, the crack stopping structure may be a row structure in which grooves and/or vias are disposed in rows (see FIG. 8, etc.) For example, the crack stopping structure may be a curved structure in which grooves and/or vias are disposed along an edge shape of the individual product (see FIG. 9, etc.)

Grooves and vias are distinguished by whether they are recessed or pass through the core in a thickness direction, and shapes of the opening may be variously applied. Various shapes such as a circle, an oval, a quadrangle, a rectangle, a rhombus, a trapezoid, a triangle, a hexagon, a polygon, and the like may be applied as the shape of the opening. In the drawings, circles, ovals, quadrangles, triangles, and the like are presented, but the present invention is not limited thereto.

The crack stopping structure 32 may be disposed in parallel with the edges of the core.

The crack stopping structure 32 may be disposed in a direction toward a center of the core from vertices of the core.

The crack stopping structure 32 may include grooves and/or vias disposed in a curved structure along shapes of the vertices of the individual product.

Although damage to the substrate, especially cracks that start at a side surface and proceed in a direction in parallel with one surface or the other surface (breakage, causes glass cohesive separation when occurring in glass) may occur due to various causes. As an example, in a process of forming a redistribution layer, it seems that shrinkage due to curing of a material repeatedly laminated on an upper surface and/or a lower surface of the core forms shrinkage shear stress on upper and lower surfaces of the substrate, and horizontal damage occurs in the substrate due to this effect. Efforts for minimizing the occurrence of this stress are necessary, but a method of structurally preventing the generation of cracks in the core despite the occurrence of this stress or preventing functional damage to the individual product due to generated cracks is also needed. Such damage frequently occurs at the edges of the core, and accordingly, it is recommended that a crack stopping structure formed in a 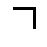 -shaped structure or 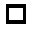 -shaped structure be disposed along the edges of the core or the edge shape of the individual product.

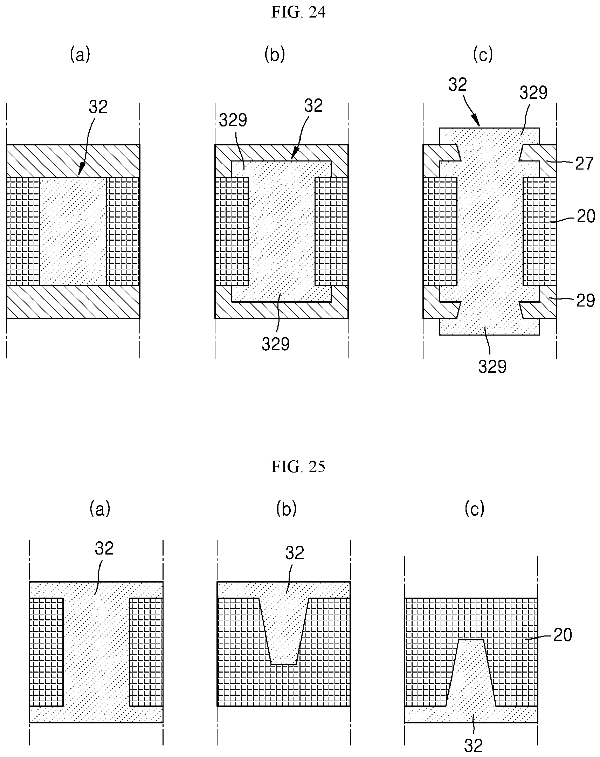

The groove or via may or may not be filled with a filler material (see FIGS. 24, 25, etc.).

The groove is a filled groove 325 filled with a filler material or a blank groove 327 having an empty space in the groove.

The via may be a filled via 323 filled with a filler material or a blank via 321 having an empty space in the via.

Any one selected from the group consisting of a metal material, an organic material, an organic-inorganic composite material, and a combination thereof may be applied as the filler material.

The organic material and the organic-inorganic composite material may be, for example, elastic materials. The elastic material may serve as a buffer by absorbing some of the stress occurring in the core when applied as the filler material.

The organic-inorganic composite material may include a glass fiber. The glass fiber may increase a bonding fore between the filler materials to further prevent damage to the substrate despite tension generated in the substrate.

When the groove or via is filled, an insulating material 111 and/or a conductive metal 131 may be filled.

The metal may be gold (Au), silver (Ag), copper (Cu), nickel (Ni), aluminum (Al), or a combination thereof.

The insulating material may be a thermosetting material, a thermoplastic material, an ultraviolet (UV) curable material, or the like. The insulating material may be a silicon-based material, an epoxy-based material, an acrylic-based material, or the like. The insulating material may be a polymer material or an organic-inorganic composite material in which inorganic particles are dispersed in a polymer material. The insulating material may be an epoxy molding compound (EMC). For example, an Ajinomoto build-up film (ABF) of Ajinomoto may be applied, but the present invention is not limited thereto.

When the groove or via is filled with an insulating material, each opening may come into contact with an insulating portion of a redistribution layer. In this case, the insulating material may effectively suppress the occurrence of glass cohesive separation in the core.

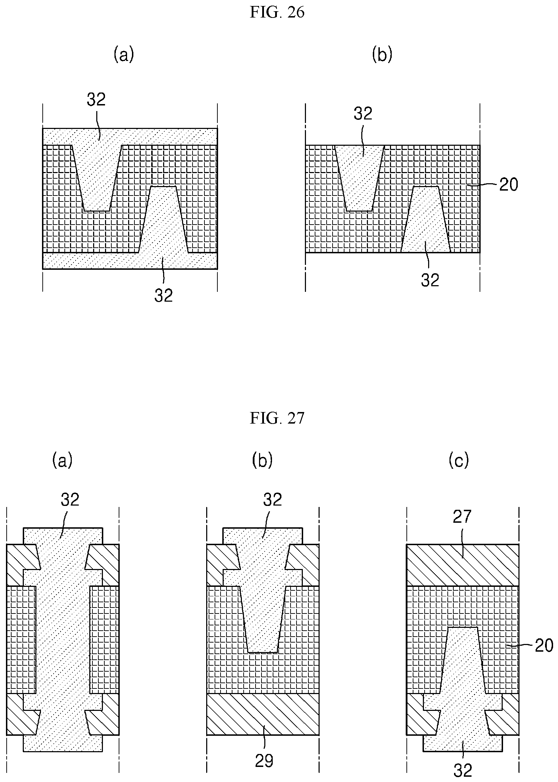

When the groove or via is filled with a metal layer (electrically conductive layer), each opening may contact the via pad 329 (see FIG. 24 (b)). Additionally, the via pad 329 may contact a blind via disposed in the redistribution layer (see FIGS. 24(c) and 27). Through this, the via or groove may serve as a crack-stopping structure and at the same time serve as a heating via or electrically conductive via.

The crack stopping structure 32 may suppress the occurrence of cracks from the side of the core.

The crack stopping structure 32 may stop cracks occurring from the side of the core from growing toward the center of the individual product.

The crack stopper structure 32 may include a filled via filled with an insulating material, or a filled groove whose diameter becomes smaller as it goes inside the groove (see FIG. 25.)

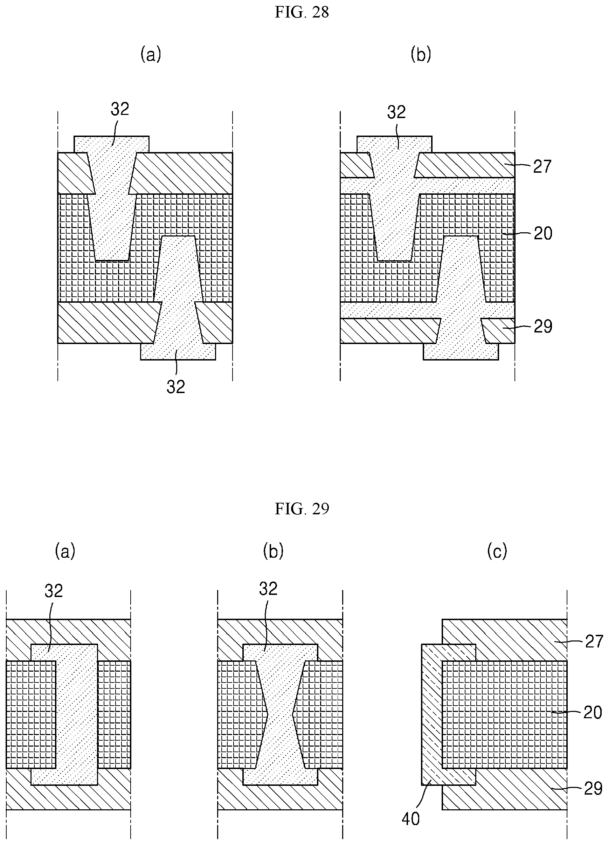

The crack stopping structure 32 may include filling grooves arranged side by side with the diameter becoming smaller as they go inside the grooves, each having openings on the upper and lower surfaces (see FIGS. 26 and 28.)

The crack stopping structure 32 is in contact with the pad at openings on the upper and lower surfaces, respectively, and may be a structure that penetrates the core, and may be in a " 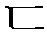 (C)" shape surrounding the edge of the product area (see Figure 29.)

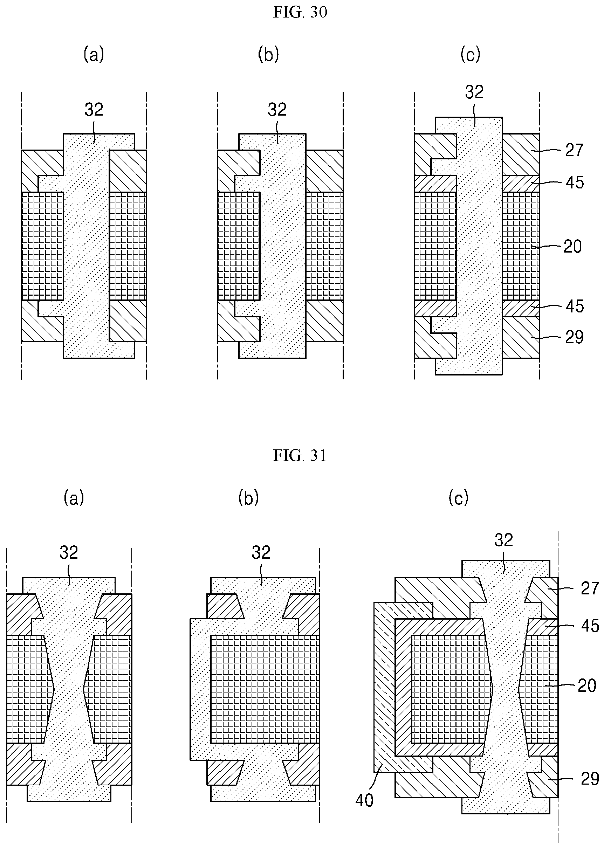

In addition, the crack stopping structure 32 has through vias in contact with pads at openings on the upper and lower surfaces, respectively, and the pads on the upper and lower surfaces may be connected to blind vias and pads on the blind vias, respectively. At this time, the blind via may be formed in the upper redistribution layer or the lower redistribution layer (see FIGS. 30, 31, etc.)

The crack stopping structure 32 may further include a side surface protection layer 40 (see FIGS. 19, 20, etc.)

The side surface protection layer 40 is a layer that covers part or all of side surfaces of the core.

The side surface protection layer 40 may include a filler material that fills the vias or grooves.

A surface including the side surface of the core, a portion of the upper surface connected to the side surface, and a portion of the lower surface connected to the side surface is a side surface to be protected

The side surface protection layer 40 may be disposed on part or all of the side surface to be protected.

The side surface protection layer 40 may include any one selected from the group consisting of a metal, a polymer, a glass fiber, and a combination thereof.

The side surface protection layer 40 may cover the side surface of the core to help suppress the growth of damage that may occur at the side surfaces or edges of the core.

The substrate 10 may further include a stabilization layer 45 configured to cover the core (see FIGS. 16, 18, etc.)

The stabilization layer 45 may be a layer that covers surfaces including the upper surface and the lower surface of the core.

The stabilization layer 45 may be a layer surrounding the upper and lower surfaces of the core and the side surfaces connecting them.

The stabilization layer 45 may include any one selected from the group consisting of a metal, a polymer, a glass fiber, and a combination thereof.

The stabilization layer 45 may be a layer including a filler material.

The stabilization layer 45 may include an insulating layer.

The side surface protection 40 layer may include an insulating layer.

The insulating layer may include inorganic particles dispersed in a polymer resin.

The core may have a cavity (not shown).

The core may further include a cavity space disposed at one surface or both surfaces.

The individual substrate may further include a cavity space disposed at one surface or both surfaces of the core.

The cavity space is a space in which a portion of the core is recessed, and thus part or all of an element is embedded.

Figure 14 is a conceptual diagram explaining the packaging substrate 90. An upper redistribution layer (27, in the drawing, the redistribution wire is not shown) of the core 20 may be disposed on one surface of the core. A lower redistribution layer (29, in the drawing, the redistribution wire is not shown) may be disposed under the other surface of the core. The groove or via of the crack stopping structure 32 may be connected to the upper redistribution layer or the lower redistribution layer. Shoulder resists 60 may be disposed above and below the upper redistribution layer 27 and the lower redistribution layer 29, respectively. A connection structure such as a bump 52 may be further disposed under the lower redistribution layer 29.

FIGS. 15 and 17 are conceptual diagrams each illustrating a semiconductor module in cross section. The semiconductor module 900 includes a substrate and elements 80 mounted on the substrate.

The semiconductor module includes a substrate 10 and an element mounted on the substrate. The above-described substrate is applied as the substrate. A substrate having a core made of plate glass may be applied as the substrate.

An active element, and/or a passive element may be applied as the element 80.

For example, the active element may include any one of an application processor (AP), a power management integrated circuit (PMIC), a central processing unit (CPU), a controller, and an application specific integrated circuit (ASIC).

For example, the passive element may include any one of a capacitor, a resistor, and an inductor.

A structure commonly applied to a semiconductor module, such as a bump structure, which connects elements or the like, may be applied to the embodiment.

A substrate of an embodiment can substantially suppress the occurrence of damage in packaging substrates, which are individual products, and a product region where the packaging substrates are gathered due to damage such as cracks occurring at side surfaces or edges of the substrate.

A semiconductor module of an embodiment can provide a packaging substrate having excellent characteristics obtained in high yield using the substrate. Specifically, an excellent manufacturing yield can be obtained even when a substrate having characteristics, such as plate glass, is applied as a core.

Although preferable embodiments of the present disclosure have been described above in detail, the scope of the present disclosure is not limited thereto, and various modifications and improvements made by those skilled in the art using the basic concepts of the present disclosure also belong to the scope of the present disclosure.

## Claims

1. A substrate, comprising a core as a glass or ceramic support,
wherein the substrate is divided into a product region and a dummy region, the product region is a region where one or more individual products are disposed, the dummy region is a region of the substrate other than the product region,
wherein a breakage prevention portion is disposed in the product region or the dummy region, the breakage prevention portion is a region in which one or more crack stopping structures are disposed, and the crack stopping structure is grooves or vias who stops cracks generated from the side of the core from growing toward the center of the individual product, and
wherein the groove is a depression in a surface of the core, and the via is a through hole that has been removed so that a portion of the core being penetrate in a thickness direction.

2. The substrate of claim 1, wherein individual product has a cutting line, a center point, and an inner border when viewed from above,
the cutting line is a line forming an outline of the individual product when the individual product is separated,
the center point is an imaginary point corresponding to a geometric center of the individual product, and
the inner border line is an imaginary line that approaches the center point as much as 20% of a length from the cutting line.

3. The substrate of claim 1,
wherein the breakage prevention portion comprises a plurality of grooves or vias disposed adjacent to a boundary line between the product area and the dummy area.

4. The substrate of claim 1,
wherein the groove or via has an opening having a diameter A, and a pitch of the grooves or vias adjacent to each other is 1.3 to 20 times of A.

5. The substrate of claim 1,
wherein the crack stopping structure comprises a curved structure in which the grooves or vias are disposed along a shape of an edge of the individual product.

6. The substrate of claim 1,
wherein the groove is a filled groove, the via is a filled via, and an opening of the groove or via comes into contact with a via pad.

7. The substrate of claim 1,
wherein the crack stopping structure further comprises a side surface protection layer which is a structure covering a part or all of side surfaces of the core.

8. The substrate of claim 1, further comprising a stabilization layer, and
wherein the stabilization layer covers surfaces comprising an upper surface and a lower surface of the core.

9. The substrate of claim 7,
wherein a surface comprising the side surface of the core, a portion of the upper surface connected to the side surface, and a portion of the lower surface connected to the side surface are a side surface to be protected, and
the side surface protection layer is disposed on part or all of the side surface to be protected.

10. The substrate of claim 7 or claim 8, wherein the stabilization layer comprises an insulating layer and the side surface protection layer comprises an insulating layer.
